# EUROPÄISCHE PATENTSCHRIFT

(11) **EP 2 481 123 B1**
(45) Veröffentlichungstag und Bekanntmachung des Hinweises auf die Patenterteilung: **18.09.2013**
(21) Anmeldenummer: 10751808.6
(22) Anmeldetag: 26.08.2010
(51) Int. Cl.: H01M 10/48

(54) **VERFAHREN ZUR STEUERUNG BZW. REGELUNG MINDESTENS EINES DEN ALTERUNGSZUSTAND EINES ELEKTRISCHEN ENERGIESPEICHERS BEEINFLUSSENDEN BETRIEBSPARAMETERS**
METHOD FOR CONTROLLING AT LEAST ONE OPERATING PARAMETER THAT INFLUENCES THE AGING STATE OF AN ELECTRICAL ENERGY STORE IN AN OPEN-LOOP OR CLOSED-LOOP MANNER
PROCÉDÉ DE COMMANDE ET/OU DE RÉGULATION D'AU MOINS UN PARAMÈTRE DE FONCTIONNEMENT INFLUANT SUR L'ÉTAT DE VIEILLISSEMENT D'UN ACCUMULATEUR D'ÉNERGIE ÉLECTRIQUE

(30) Priorität: 23.09.2009 DE 102009042656
(43) Veröffentlichungstag der Anmeldung: 01.08.2012
(73) Patentinhaber: Bayerische Motoren Werke Aktiengesellschaft, 80809 München (DE)
(72) Erfinder: MUMELTER, Georg, 80807 München (DE); JONASCH, Felix, 8057 Zürich (CH); HOFMEIER, Harald, 80807 Muenchen (DE); BOECKL, Michael, 81677 Muenchen (DE); ROGGE, Simon, 81243 Muenchen (DE)
(86) Internationale Anmeldenummer: PCT/EP2010/005233
(87) Internationale Veröffentlichungsnummer: WO 2011/035837

(56) Entgegenhaltungen:
- EP-A1- 1 983 602

## Beschreibung

Verfahren zur Steuerung bzw. Regelung mindestens eines den Alterungszustand eines elektrischen Energiespeichers beeinflussenden Betriebsparameters

Die vorliegende Erfindung betrifft ein Verfahren zur Steuerung bzw. Regelung mindestens eines den Alterungszustand eines elektrischen Energiespeichers beeinflussenden Betriebsparameters gemäß dem Oberbegriff des Patentanspruches 1.

Aus der EP 1983 602 ist ein Verfahren zur Minderung der Alterung einer Batterie bekannt, wobei der Ladezustand der Batterie überwacht wird. Zur Ermittlung des Alterungszustandes wird der innere Batteriewiderstand gemessen und mit einem Referenzwert verglichen, wobei der Referenzwert unabhängig vom Alter der Batterie ist.

Hybridfahrzeuge sind mit einem Hochvoltspeicher (Batterie) ausgestattet, der elektrische Energie zur Versorgung eines elektrischen Antriebsmotors speichert. Derartige Hochvoltspeicher sind teuer und sollten daher möglichst auf die Lebensdauer des Fahrzeugs ausgelegt sein. Bekanntlich unterliegen Batterien einer physikalischen Alterung, die von einer Vielzahl von Parametern abhängt, wie z. B. der Betriebstemperatur der Batterie über der Zeit, der Anzahl der Lade- und Entladezyklen, der Lade- und bzw. Entladehübe etc.

Aus der JP 111 655 40 ist beispielsweise bekannt, eine Batterie durch eine Spannungsbegrenzung bzw. einen Über- und Unterladeschutz vor zu starker Belastung und somit zu schneller Alterung zu schützen. Verfahren zur Kühlung bzw. zur Strombegrenzung von Batterien sind aus der CN 1012 22077 oder der JP 2005012929 bekannt. Zum technischen Hintergrund der vorliegenden Erfindung zählen ferner die DE 10 2008 009 568.0, US 567 2951, JP 6140080, WO 07114410, JP 2007216707, JP 2005125916, JP 2008196852, US 2005001625, DE 102007023901, DE 102007012127 sowie die JP 2004186087.

Im Stand der Technik wird versucht, eine Beschädigung des elektrischen Energiespeichers durch Festlegen konstanter oder leicht dynamischer Grenzwerte, z. B. für die Peak- und Dauerleistung, die zulässige Spannung oder den Ladezustand etc., zu vermeiden. Elektrische Energiespeicher altern aber auch innerhalb fest oder dynamisch vorgegebener Betriebsgrenzen, insbesondere beim Aufladen, beim Entladen sowie durch hohe thermische Belastung.

Aufgabe der Erfindung ist es, ein Verfahren zu Steuerung bzw. Regelung mindestens eines den Alterungszustand eines elektrischen Energiespeichers beeinflussenden Betriebsparameters anzugeben, welches es ermöglicht, den Energiespeicher bestmöglich über eine vorgegebene Soll-Lebensdauer zu nutzen.

Diese Aufgabe wird durch die Merkmale des Patentanspruches 1 gelöst. Vorteilhafte Ausgestaltungen und Weiterbildungen der Erfindung sind den Unteransprüchen zu entnehmen.

Das Grundprinzip der Erfindung besteht darin, den Alterungszustand eines Energiespeichers zu überwachen und mit einem vorgegebenen Soll-Alterungszustand zu vergleichen und den zulässigen Wertebereich bzw. den zugelassenen Betriebsparameterbereich mindestens eines beeinflussbaren Betriebsparameters des Energiespeichers "bei Bedarf" einzuschränken, mit dem Ziel, dass der Energiespeicher bis zum Ende seiner vorgegebenen Soll-Lebensdauer funktionsfähig bleibt, d. h. vorgegebene Mindestkriterien bis zum Ende der vorgegebenen Soll-Lebensdauer erfüllt.

Der Begriff "elektrischer Energiespeicher" umfasst insbesondere Batterien bzw. Akkumulatoren für Elektrofahrzeuge oder Hybridfahrzeuge.

Die Einschränkung des zulässigen Werts bzw. des zugelassenen Betriebsparameterbereichs erfolgt nur bei Bedarf, d. h. wenn der tatsächliche Alterungszustand des Energiespeichers schlechter ist als ein für das "momentane Lebensalter" des Energiespeichers vorgegebener bzw. erwarteter Soll-Alterungszustand.

Anstatt des Begriffs "Alterungszustand" wird in der vorliegenden Patentanmeldung auch der Begriff "State of Health" bzw. das entsprechende Akronym "SoH" verwendet.

Nach einer Weiterbildung der Erfindung wird der tatsächliche Alterungszustand des Energiespeichers in Abhängigkeit vom Innenwiderstand des Energiespeichers und/oder in Abhängigkeit von der Kapazität des Energiespeichers ermittelt.

Vorzugsweise wird der tatsächliche Alterungszustand des Energiespeichers in Abhängigkeit von einem gemessenen Ist-Innenwiderstand und der ermittelten Ist-Kapazität des Energiespeichers ermittelt. Verfahren zur Ermittlung der Kapazität eines Energiespeichers sind aus dem Stand der Technik bekannt (z.B. EP 1962 099 A2) und brauchen daher hier nicht näher erläutert werden.

Sowohl der Innenwiderstand als auch die Kapazität oder eine Verknüpfung beider Eigenschaften können als Indizien bzw. als Maß oder als wichtige Bestimmungsgrößen für den Alterungszustand eines Innenwiderstands verwendet werden. Mit sich verschlechterndem Alterungszustand steigt der Innenwiderstand eines Energiespeichers. Die Kapazität eines elektrischen Energiespeichers nimmt hingegen mit sich verschlechterndem Alterungszustand ab.

Entscheidenden Einfluss auf die Alterung eines elektrischen Energiespeichers hat dessen thermische Belastung, die wiederum von der Umgebungstemperatur, der beim Auf- und Entladen entstehenden Wärme und der Kühlung des elektrischen Energiespeichers abhängt.

Bei der gemäß der Erfindung vorgesehenen "SoH-basierten Regelung" kann beispielsweise die Abhängigkeit zwischen der Entladetiefe ("Depth of Discharge" bzw. oder "DoD") und der zyklischen Belastung des Energiespeichers als "Stellgröße" genutzt werden, um die Alterungsgeschwindigkeit, wenn nötig, zu verlangsamen. So kann beispielsweise auf die "Energiehübe" beim Auf- und Entladen Einfluss genommen werden. Bekanntermaßen ist bei kleineren Energiehüben die Speicherdegradierung und somit die Alterungsgeschwindigkeit geringer als bei größeren Energiehüben.

Gemäß der Erfindung erfolgt die Steuerung bzw. Regelung des mindestens einen den Alterungszustand des elektrischen Energiespeichers beeinflussenden Betriebsparameters in Abhängigkeit von der so genannten "relativen Abweichung" dSoHᵣₑₗ des tatsächlichen Alterungszustands des Energiespeichers von dem für das momentane Alter des Energiespeichers erwarteten Alterungszustands, der in der vorliegenden Beschreibung und in den Patentansprüchen auch als "Soll-Alterungszustand" bezeichnet wird. Gemeint ist damit natürlich nicht ein anzustrebender Alterungszustand, sondern dass der tatsächliche Alterungszustand des Energiespeichers höchstens so "schlecht" wie der Soll-Alterungszustand sein sollte, vorzugsweise aber besser.

Die relative Abweichung dSoHᵣₑₗ wird gemäß der Erfindung als Eingangsgröße eines Reglers bzw. einer Steuerung verwendet, welche bei Bedarf den zulässigen Wertebereich mindestens eines den Alterungszustand des Energiespeichers beeinflussenden Betriebsparameters einschränkt, um bis zum Ende einer vorgegebenen Soll-Lebensdauer des Energiespeichers eine gewisse Mindestfunktionalität sicherzustellen.

Nach einer Weiterbildung der Erfindung hat es sich bei dem mindestens einen Betriebsparameter um den Ladezustand des Energiespeichers, der auch als "State of charge" bzw. mit dem Akronym "SoC" bezeichnet wird.

Es kann vorgesehen sein, dass die Maximalladungsgrenze, bis zu der der Energiespeicher aufgeladen werden darf, von der Steuerung bzw. Regelung abgesenkt wird, falls der tatsächliche SoH unter den Soll-Alterungszustand SoH_{Soll} absinkt. Durch die Absenkung der Maximalladungsgrenze verringert sich entsprechend die mögliche Entladetiefe, was die Alterungsgeschwindigkeit des Energiespeichers verringert. Durch eine Absenkung der Maximalladungsgrenze verringert sich zwar die effektiv zur Verfügung stehende, im Energiespeicher gespeicherte Energiemenge. Man nimmt dies aber bewusst in Kauf, um sicherzustellen, dass eine vorgegebene Soll-Lebensdauer erreicht werden kann.

Nach einer Weiterbildung der Erfindung kann vorgesehen sein, dass die Änderungsgeschwindigkeit, d.h. der Gradient, mit dem die Maximalladungsgrenze reduziert wird, beschränkt wird, um dem Kunden bzw. Nutzer des Energiespeichers allmählich und nicht schlagartig an eine Verringerung der Maximalladungsgrenze zu gewöhnen.

Zusätzlich oder alternativ zur Absenkung der Maximalladungsgrenze SoCₘₐₓ kann die zulässige untere Ladungsgrenze SoCₘᵢₙ, bis zu der der Energiespeicher entladen werden darf, bei Unterschreiten des Soll-Alterungszustandes angehoben werden, um auch bei einem gealterten Energiespeicher stets die für einen Kaltstart des Fahrzeugs erforderliche elektrische Energie vorzuhalten. Es kann vorgesehen sein, dass die Anhebung der Minimalladungsgrenze SoCₘᵢₙ unabhängig von der Stärke der Alterung und der SoH Regelung über SoCₘₐₓ erfolgt.

Gemäß der Erfindung kann eine Betriebsstrategie vorgesehen, welche die aus dem Stand der Technik bekannten Methoden zum Schutz des Energiespeichers zusätzlich erweitert. Elektrische Speicher altern insbesondere bei sehr hohen Strömen bzw. hoher Leistungsentnahme. Um die Alterung des elektrischen Speichers einzuschränken bzw. zu kontrollieren, kann vorgesehen sein, dass abhängig von der relativen Abweichung dSoHᵣₑₗ des aktuellen Alterungszustands SoHₐₖₜ vom Sollalterungszustand SoH_{Soll} die maximal zulässige bzw. verfügbare Lade- und Entladeleistung eingeschränkt wird. Vorgegebene Leistungsgrenzen, die auch als dynamische Leistungsgrenzen, d. h. beispielsweise zeitabhängige Leistungsgrenzen oder vom Spannungslevel abhängige Leistungsgrenzen vorgegeben sein können, werden hierzu mit einem Wichtungsfaktor zwischen Null und Eins multipliziert. Um den Eingriff der Steuerung bzw. Regelung für den Kunden bzw. Nutzer unmerkbar zu gestalten, kann der maximale Gradient des Wichtungsfaktors sowie seine Untergrenze beschränkt werden. Durch diesen Eingriff werden, wenn nötig, Leistungsspitzen vermieden. Entsprechend sinkt auch die thermische Belastung des Speichers.

Als zusätzliche Eingriffsmöglichkeit kann vorgesehen sein, dass Temperaturgrenzen dynamisch angepasst werden. Die aus dem Stand der Technik bekannten statischen Grenzwerte definieren, ab welcher Temperatur der Speicher gekühlt bzw. ab welcher Temperatur die Kühlung wieder deaktiviert wird. Derartige statische Temperaturgrenzen halten die Speichertemperatur unterhalb eines gewissen Werts. Falls jedoch die Alterung des Energiespeichers in signifikanter Weise durch die thermische Belastung bestimmt ist, z. B. im Falle einer Fahrzeugnutzung in einem "Heissland", kann eine Anpassung der Temperaturgrenzen sinnvoll sein. In Abhängigkeit vom tatsächlichen Alterungszustand des Energiespeichers können diese Temperaturgrenzen verändert, insbesondere abgesenkt werden. Durch eine Absenkung der Temperaturgrenzen wird die Durchschnittstemperatur des elektrischen Speichers tiefer liegen und die Abkühlzeit des elektrischen Speichers beim Abstellen des Fahrzeugs verkürzt. Um die Regelung für den Kunden unmerkbar zu gestalten, kann auch hier vorgesehen sein, dass der Gradient der Absenkung der Temperaturgrenzen beschränkt wird.

Im Folgenden wird die Erfindung im Zusammenhang mit der Zeichnung näher erläutert.
- Figur 1: zeigt ein Diagramm zur Verdeutlichung des grundsätzlichen Prinzips einer Alterungsregelung gemäß der Erfindung;
- Figur 2: ein Flussdiagramm, welches den Algorithmus zur Einschränkung der SoC-Grenzen beschreibt; und
- Figur 3: das Grundprinzip einer Alterungsregelung, bei der mehrere Betriebsparameter berücksichtigt werden.

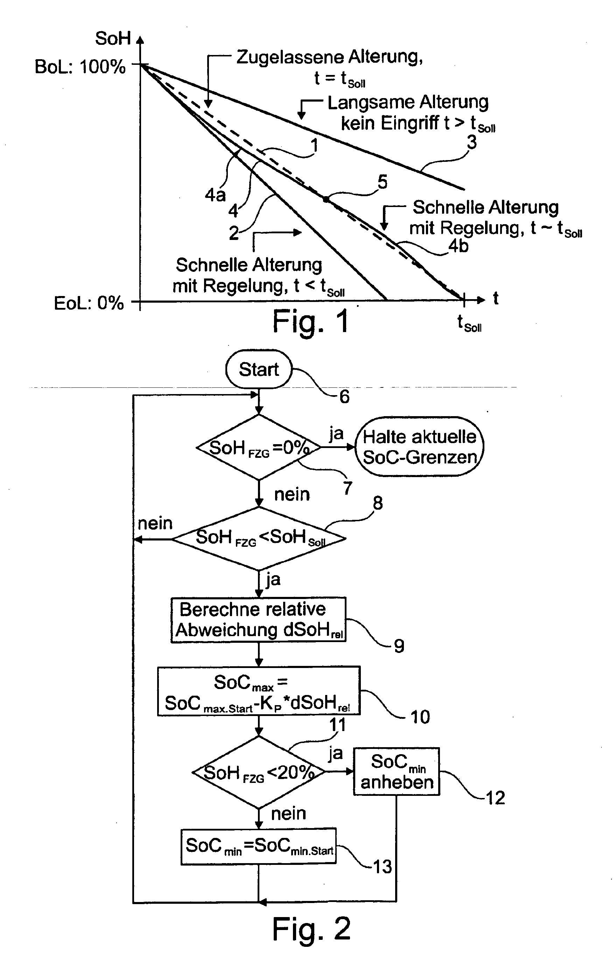

In Figur 1 ist auf der Abszisse die Zeit t bzw. die "Lebensdauer" einer Hochvoltbatterie eines Fahrzeugs und auf der Ordinate der Alterungszustand SoH eines Energiespeichers aufgetragen.

Die mit 1 gekennzeichnete gestrichelte Linie beschreibt die zulässige Alterung des Energiespeichers über der Zeit. Ausgehend von einem Ausgangszustand BoL von 100%, bei dem der Energiespeicher seine volle Leistungsfähigkeit aufweist, altert der Energiespeicher, d. h. seine Leistungsfähigkeit sinkt auf einen Alterungszustand EoL von 0%. 0% bedeutet in diesem Zusammenhang, dass der Energiespeicher gerade noch eine vorgegebene Mindestleistungsfähigkeit aufweist und nicht, dass er überhaupt nicht mehr funktioniert. t_{Soll} ist die Solllebensdauer, bis zu der der Energiespeicher zumindest soweit funktionsfähig sein soll, dass vorgegebene Funktionen erfüllt werden.

Die mit 2 gekennzeichnete Alterungslinie beschreibt eine zu schnelle Alterung. Bei zu schneller Alterung erreicht der Energiespeicher nicht die vorgesehene Solllebensdauer t_{Soll}, zumindest nicht unter Erfüllung vorgegebener Sollleistungskriterien.

Die mit 3 gekennzeichnete Linie beschreibt eine langsamere Alterung als die vom Hersteller erwartete mit 1 gekennzeichnete Alterung.

Die mit 4 gekennzeichnete Alterungslinie beschreibt einen Alterungsverlauf, bei dem die Alterungsregelung gemäß der Erfindung eingreift. In einem Bereich 4a ist der tatsächliche Alterungszustand des Energiespeichers schlechter als der Sollalterungszustand. Dementsprechend liegt im Bereich 4a die Alterungslinie unterhalb der zulässigen Alterungslinie 1. Im Bereich 4a ist die Alterungslinie 4 konkav gekrümmt, was anzeigt, dass die Alterungsregelung bereits eingreift. Im Punkt 5 schneidet die Alterungslinie 4 die Soll-Alterungslinie 1 und weicht im Bereich 4b nur noch sehr wenig von der Sollalterungslinie 1 ab. Durch Eingriff der Alterungsregelung wird gerade die angestrebte Solllebensdauer t_{Soll} erreicht.

Figur 2 beschreibt einen Algorithmus zur Einschränkung der Ladezustandsgrenzen. Ausgehend von einem Startschritt 6 wird überprüft, ob der tatsächliche Alterungszustand SoH_{FZG} 0% beträgt. Ist dies der Fall, so werden die aktuellen Ladezustandsgrenzen gehalten. Ist dies nicht der Fall, so wird überprüft, ob der tatsächliche Alterungszustand SoH_{FZG} kleiner als der Sollalterungszustand SoH_{Soll} ist. Ist dies nicht der Fall, so wird nach Durchlaufen des Schritts 8 zu Schritt 7 zurückgesprungen. Ist dies der Falls so wird die relative Abweichung dSoHᵣₑₗ berechnet, wobei gilt, dSoHᵣₑₗ = SoH_{FZG} - SoH_{Soll}.

In Schritt 10 wird die obere zulässige Ladezustandsgrenze SoCₘₐₓ gemäß der Erfindung SoCₘₐₓ = SoCₘₐₓ, _{Start} - K_{P} x dSoHᵣₑₗ angepasst.

K_{P} ist ein Proportionalitätsfaktor. SoC_{max,Start} ist ein für den neuwertigen Energiespeicher vorgegebener Startwert für die zulässige obere Ladezustandsgrenze.

In Schritt 11 wird überprüft, ob der tatsächliche Alterungszustand SoH_{FZG} kleiner als 20% ist. Ist dies der Fall, so wird in Schritt 12 die zulässige untere Ladezustandsgrenze SoCₘᵢₙ angehoben und zu Schritt 7 zurückgesprungen. Ist der tatsächliche Alterungszustand SoH_{FZG} hingegen größer oder gleich 20%, so wird eine für den neuwertigen Energiespeicher vorgegebene zulässige untere Ladezustandsgrenze SoC_{min,} start beibehalten.

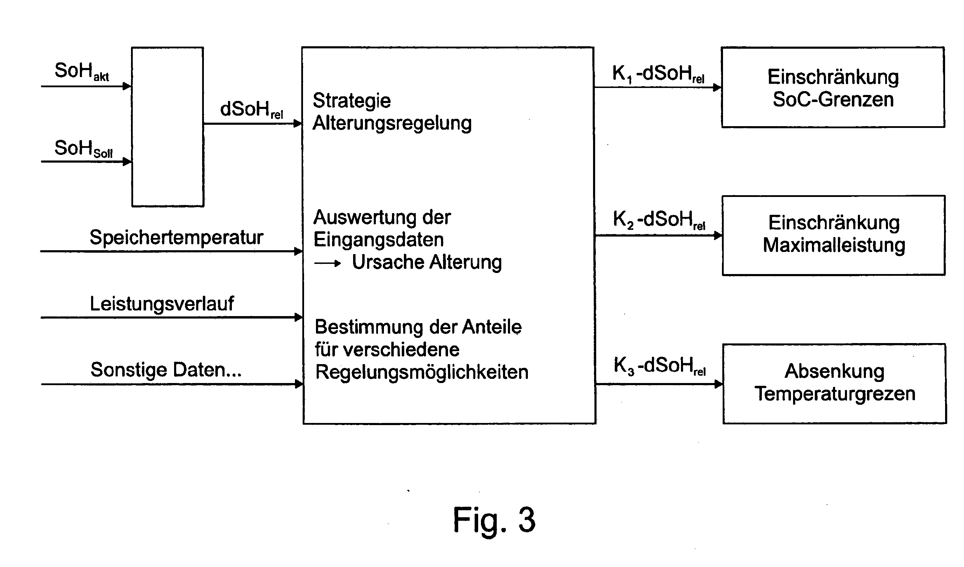

Figur 3 zeigt das Grundprinzip der Erfindung unter Berücksichtigung mehrerer Betriebszustandsparameter.

Aus dem tatsächlichen Alterungszustand SoHₐₖₜ und dem für das momentane Alter des Energiespeichers vorgegebenen Sollalterungszustands SoH_{Soll} wird die relative Abweichung dSoHᵣₑₗ gebildet. Ferner berücksichtigt werden die Temperatur- bzw. der bisherige Speichertemperaturverlauf, der Leistungsverlauf der dem Speicher zugeflossenen elektrischen Leistung und/oder dem Speicher entzogenen elektrischen Leistung und evtl. weitere den Alterungszustand des elektrischen Speichers beeinflussende Betriebsparameter.

In Abhängigkeit von diesen Eingangsgrößen können die untere und/oder die obere zulässige Ladezustandsgrenze und somit der zulässige Ladezustandsbereich eingeschränkt werden und/oder die maximal zulässige Lade- und/oder Entladeleistung des Energiespeichers verringert werden und/oder die Temperaturgrenzen, ab der der elektrische Energiespeicher gekühlt werden muss und/oder bis zu der der elektrische Energiespeicher gekühlt werden darf, angepasst werden, wenn der tatsächliche Alterungszustand SoHₐₖₜ schlechter als der Sollalterungszustand SoH_{Soll} ist.

## Patentansprüche

1. Verfahren zur Steuerung bzw. Regelung mindestens eines den Alterungszustand eines elektrischen Energiespeichers beeinflussenden Betriebsparameters des elektrischen Energiespeichers, **gekennzeichnet durch** folgende Schritte:
- Ermitteln des tatsächlichen Alterungszustands (SoHₐₖₜ, SoH_{FZG}) des elektrischen Energiespeichers,
- Vergleichen des tatsächlichen Alterungszustands (SoHₐₖₜ, SoH_{FZG}) mit einem für das momentane Alter (t) des Energiespeichers vorgegebenen Soll-Alterungszustand (SoH_{Soll}).
- Einschränken eines für den mindestens einen Betriebsparameter zugelassenen Betriebsparameterbereichs, wenn der tatsächliche Alterungszustand (SoHₐₖₜ, SoH_{FZG}) schlechter als der Soll-Alterungszustand (SoH_{Soll}) ist.

2. Verfahren nach Anspruch 1, **dadurch gekennzeichnet, dass** der tatsächliche Alterungszustand (SoHₐₖₜ, SoH_{FZG}) des Energiespeichers in Abhängigkeit vom Innenwiderstand des elektrischen Energiespeichers ermittelt wird.

3. Verfahren nach Anspruch 2, **dadurch gekennzeichnet, dass** der Innenwiderstand gemessen wird.

4. Verfahren nach einem der Ansprüche 1 bis 3, **dadurch gekennzeichnet, dass** der tatsächliche Alterungszustand (SoHₐₖₜ, SoH_{FZG}) des elektrischen Energiespeichers in Abhängigkeit von der Ist-Kapazität des elektrischen Energiespeichers ermittelt wird.

5. Verfahren nach Anspruch 4, **dadurch gekennzeichnet, dass** der tatsächliche Alterungszustand (SoHₐₖₜ, SoH_{FZG}) des elektrischen Energiespeichers in Abhängig von dessen Innenwiderstand und dessen Ist-Kapazität ermittelt wird.

6. Verfahren nach einem der Ansprüche 1 bis 5, **dadurch gekennzeichnet, dass** es sich bei dem mindestens einen Betriebsparameter um den Ladezustand des elektrischen Energiespeichers handelt, wobei der der zulässige Ladezustandsbereich in Bezug auf den momentan noch zulässigen Ladezustandsbereich eingeschränkt wird, wenn der tatsächliche Alterungszustand (SoHₐₖₜ, SoH_{FZG}) schlechter als der Soll-Alterungszustand (SoH_{Soll}) ist.

7. Verfahren nach einem der Ansprüche 1 bis 6, **dadurch gekennzeichnet, dass** es sich bei dem mindestens einen Betriebsparameter um die Lade- und/oder Entladeleistung des elektrischen Energiespeichers handelt, wobei der Bereich zulässiger Lade- bzw. Entladeleistungen in Bezug auf den momentan noch zulässigen Bereich eingeschränkt wird, wenn der tatsächliche Alterungszustand (SoHₐₖₜ, SoH_{FZG}) schlechter als der Soll-Alterungszustand (SoH_{Soll}) ist.

8. Verfahren nach einem der Ansprüche 1 bis 7, **dadurch gekennzeichnet, dass** es sich bei dem mindestens einen Betriebsparameter um eine Energiespeichertemperatur handelt, wobei der zulässige Energiespeichertemperaturbereich in Bezug auf den momentan noch zulässigen Energiespeichertemperaturbereich eingeschränkt wird, wenn der tatsächliche Alterungszustand (SoHₐₖₜ, SoH_{FZG}) schlechter als der Soll-Alterungszustand (SoH_{Soll}) ist.

## Claims

1. A method of open or closed-loop control of at least one operating parameter influencing the ageing of an electric energy storage, **characterised by** the following steps:
- determining the actual ageing (SoHₐₖₜ, SoH_{FZG}) of the electric energy storage,
- comparing the actual ageing (SoHₐₓₜ, SoH_{FZG}) with a set ageing state (SoHₛₒₗₗ) preset for the instantaneous age (t) of the energy storage, and
- defining a permitted range of the at least one operating parameter when the actual ageing (SoHₐₖₜ, SoH_{FZG}) is worse than the set ageing (SoHₛₒₗₗ).

2. A method according to claim 1, **characterised in that** the actual age (SoHₐₖₜ, SoH_{FZG}) of the energy storage is determined in dependence on the internal resistance thereof.

3. A method according to claim 2, **characterised in that** the internal resistance is measured.

4. A method according to any of claims 1 to 3, **characterised in that** the actual ageing (SoHₐₖₜ, SoH_{FZG}) of the electric energy storage is determined in dependence on the actual capacitance thereof.

5. A method according to claim 4, **characterised in that** the actual ageing (SoHₐₖₜ, SoH_{FZG}) of the electric energy storage is determined in dependence on its internal resistance and its actual capacitance.

6. A method according to any of claims 1 to 5, **characterised in that** the at least one operating parameter is the charge of the electric energy storage, wherein the permitted charge range is restricted relative to the instantaneous still permitted charge range if the actual ageing (SoHₐₖₜ, SoH_{FZG}) is worse than the set ageing (SoHₛₑₜ).

7. A method according to any of claims 1 to 6, **characterised in that** the at least one operating parameter is the charging and/or discharging capacity of the electric energy storage, wherein the range of permitted charging or discharging capacities is restricted relative to the instantaneous still permitted range if the actual ageing (SoHₐₖₜ, SoH_{FZG}) is worse than the set ageing (SoHₛₒₗₗ).

8. A method according to any of claims 1 to 7, **characterised in that** the at least one operating parameter is an energy storage temperature, wherein the permitted energy storage temperature range is restricted relative to the instantaneous still permitted energy storage temperature range if the actual ageing (SoHₐₖₜ, SoH_{FZG}) is worse than the set ageing (SoHₛₒₗₗ) .

## Revendications

1. Procédé de commande ou de régulation d'au moins un paramètre de fonctionnement influençant l'état de vieillissement d'un accumulateur d'énergie électrique pour un accumulateur d'énergie électrique, **caractérisé par** les étapes suivantes consistant à :
- déterminer l'état de vieillissement effectif (SoHₐₖₜ, SoH_{FZG}) de l'accumulateur d'énergie électrique,
- comparer l'état de vieillissement effectif (SoHₐₖₜ, SoH_{FZG}) avec un état de vieillissement de consigne (SoH_{Soll}) correspondant à l'âge instantané (t) de l'accumulateur d'énergie, et
- limiter une plage des paramètres de fonctionnement autorisés pour au moins un paramètre de fonctionnement si l'état de vieillissement effectif (SoHₐₖₜ, SoH_{FZG}) est plus mauvais que l'état de vieillissement de consigne (SoH_{Soll}).

2. Procédé selon la revendication 1,
**caractérisé en ce que**
l'état de vieillissement effectif (SoHₐₖₜ, SoH_{FZG}) de l'accumulateur d'énergie électrique se détermine en fonction de sa résistance interne.

3. Procédé selon la revendication 2,
**caractérisé en ce qu'**
on mesure la résistance interne.

4. Procédé selon l'une des revendications 1 à 3,
**caractérisé en ce que**
l'on détermine l'état de vieillissement effectif (SoHₐₖₜ, SoH_{FZG}) de l'accumulateur d'énergie électrique en fonction de sa capacité réelle.

5. Procédé selon la revendication 4,
**caractérisé en ce qu'**
on détermine l'état de vieillissement effectif (SoHₐₖₜ, SoH_{FZG}) de l'accumulateur d'énergie électrique en fonction de sa résistance interne et de sa capacité réelle.

6. Procédé selon les revendications 1 à 5,
**caractérisé en ce qu'**
au moins un paramètre de fonctionnement est le paramètre d'état de charge de l'accumulateur d'énergie électrique, la plage de l'état de fonctionnement autorisé étant limitée en référence à la plage d'état de charge instantanément encore autorisée si l'état de vieillissement effectif (SoHₐₖₜ, SoH_{FZG}) est plus mauvais que l'état de vieillissement de consigne (SoH_{Soll}).

7. Procédé selon l'une des revendications 1 à 6,
**caractérisé en ce que**
le paramètre de fonctionnement est la puissance de charge et/ou de décharge de l'accumulateur d'énergie électrique, la plage des puissances de charge/décharge autorisée étant limitée par rapport à la plage momentanément encore autorisée si l'état de vieillissement effectif (SoHₐₖₜ, SoH_{FZG}) est plus mauvais que l'état de vieillissement de consigne (SoH_{Soll}).

8. Procédé selon l'une des revendications 1 à 7,
**caractérisé en ce que**
le paramètre de fonctionnement est la température de l'accumulateur d'énergie, et la plage de température autorisée pour l'accumulateur d'énergie est limitée par rapport à la plage de température de l'accumulateur d'énergie encore momentanément autorisée si l'état de vieillissement effectif (SoH_{Soll}) est plus mauvais que l'état de vieillissement de consigne (SoHₐₖₜ, SoH_{FZG}).
